Europäisches Patentamt

European Patent Office

Office européen des brevets

(11) Publication number:
**0 259 970**
**A2**

## (12) EUROPEAN PATENT APPLICATION

(21) Application number: 87306918.1

(22) Date of filing: 05.08.87

(51) Int. Cl.⁴ **H03J 1/04 , H03J 7/18**

(30) Priority: 08.09.86 GB 8621545

(43) Date of publication of application:
**16.03.88 Bulletin 88/11**

(84) Designated Contracting States:
**DE FR NL**

(71) Applicant: **BRITISH BROADCASTING CORPORATION**
**Broadcasting House**
**London W1A 1AA(GB)**

(72) Inventor: **Ely, Stephen Robert**
**7, Woodcrest Walk**
**Reigate Surrey, RH2 0JW(GB)**

(74) Representative: **Abnett, Richard Charles et al**
**REDDIE & GROSE 16 Theobalds Road**
**London WC1X 8PL(GB)**

(54) **Radio receivers.**

(57) A radio receiver (10) comprises a signal tuning section (14) to receive broadcast radio signals. The broadcast signal is passed through a sound amplifier (16) to produce an audible output for a listener. A non-audible data signal is also transmitted with the broadcast signal and received by the radio receiver. The radio receiver also has a data decoder (22) to decode the non-audible data signal. This non-audible data will be displayed on a touch sensitive screen (26). The normal display on the screen will show time and date, as well as information about the channel to which the receiver is tuned. The screen is made touch sensitive by corresponding rows of infra red emitters and sensors along opposing sides of the screen. These enable the X-Y position of a finger placed on the screen to be determined. Thus a variety of tuning and other functions can be selected from menus displayed on the screen. The output of the screen (26) control the signal tuning section 14 via a microprocessor (24).

FIG. 1

## RADIO RECEIVERS

This invention relates to radio receivers for receiving broadcast audio signals.

A system known as the Radio Data System or RDS has been proposed to help the listener to find the station or programme of his choice. This system is described in a publication entitled "Specifications of the Radio Data System RDS for VHF/FM Sound Broadcasting" published by the European Broadcasting Union Technical Centre, Brussels, publication Tech. 3244-E, March 1984. The RDS system works by adding inaudible data signals, to act as labels, to the broadcast radio signal. These data signals can be decoded by suitably equipped receivers and used, for example, to drive a display which shows the name of the station to which the receiver is tuned. RDS also provides information to aid automatic tuning of a selected station, or of a type of programme such as "News".

However we have appreciated that the existing receivers proposed for use with the RDS system fail to exploit this data to anything like its true potential.

The invention is defined in the appended claims to which reference should now be made.

The invention will be described in more detail by way of example with reference to the drawings, in which:-

Figure 1 is a block circuit diagram of a radio receiver embodying the invention;

Figure 2 shows the information displayed on the display in normal use;

Figure 3 illustrates the information which may be displayed on the display upon touching the display;

Figure 4 illustrates an alternative form of the tuning window of the display; and

Figure 5 illustrates the display when moving out of the service area of one local station.

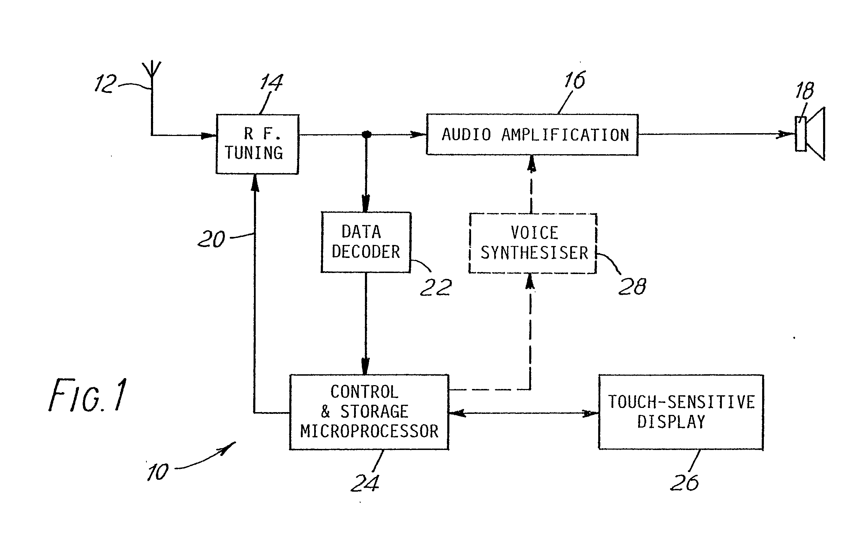

The radio receiver 10 shown in Figure 1 is designed as a car radio and has an aerial 12, RF and tuning stages 14, an audio amplification channel 16 and a loudspeaker 18 connected together in conventional fashion. The tuning circuits are responsive to a control signal received on a line 20.

The output of the RF and tuning stage 14 is also applied to a data decoder 22 which decodes data transmitted on a sub-carrier, which in the RDS system is at 57 KHz, and applies the decoded data to a microprocessor system 24 where the data is stored. Selected data is displayed on a display 26. The display is typically of 200 mm by 125 mm with a resolution of 500 by 300 pixels to display text and/or graphics. The display is made touch-sensitive, either by known capacitive techniques, or by means of a bezel laid over the display surface and which contains along two adjacent sides infra-red emitters and along the opposed two sides infra-red sensors. These sensors and emitters sense the position of a finger placed on the surface of the screen by effectively giving its X-Y co-ordinates. An enter bar is preferably provided adjacent the display to cause execution of the function selected via the touch screen.

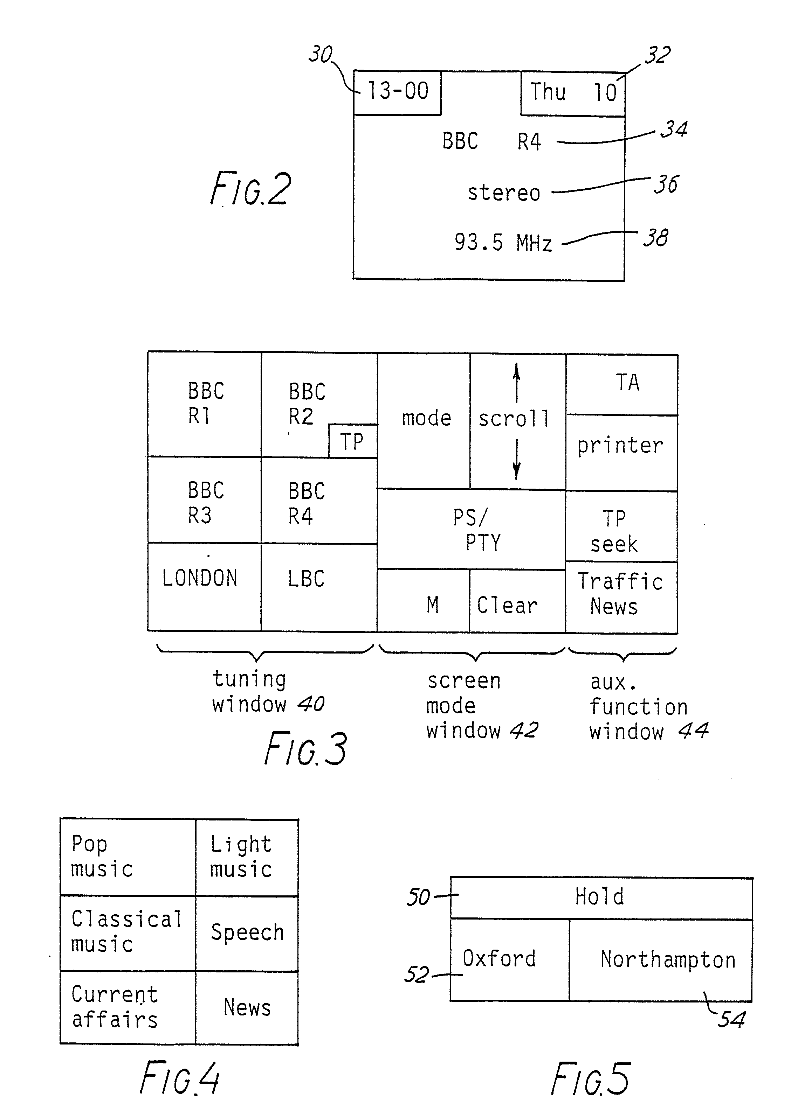

The normal display is of the type shown in Figure 2, which gives the following information:
30 Time
32 Date
34 Name of station currently being received
36 Whether it is a mono, stereo or binaural transmission
38 Frequency

Items 34 and 36 and optionally items 30 and 32 are derived from the received RDS signal.

When the listener wants to adjust the programme he places his finger on the screen. The display then changes to a menu page such as shown in Figure 3. This comprises three "windown" or sections, as follows:
40 Tuning window, which gives a menu of available stations which are "on air"
42 Screen mode window, which enables the listener to scroll up or down the stations displayed in the tuning window 40, and to select the option of display either by Programme Service name (PS), or by Programme Type code (PTY)
44 Auxiliary function window. This enables selection of special announcements for motorists and other functions related to this feature. These announcements can be broadcast on other stations, as identified by the RDS Other Network information (ON).

When in this mode the listener can select a new station by placing his finger over one of the stations shown in the tuning window and pressing the enter bar. This then causes the control microprocessor 24 to instruct the tuning stage 14 over line 20 to tune to the newly-selected station, and the display then reverts to that of Figure 2. If the desired station is not shown in the tuning window, the station display can be scrolled up or down by using the screen mode window.

The screen mode window can be used to cause the tuning window to display programme type rather than programme name as shown in Figure 4.

The listener can customise the menu screen to suit his requirements. This is achieved by operating the mode select section of the screen mode window to change between a 3 by 2 display in the tuning window, as shown, giving 6 stations visible, and a 6 by 4 display with 12 stations visible.

The user can choose the stations to be displayed in one tuning window by holding selected stations in the window. This is done by first marking the stations to be held, using area M on the screen mode window, and then scrolling to a new part of the tuning window to select and possibly hold other stations. Stations held in this way can be cleared by using the clear function in the screen mode window.

The customised screen selected in this way is stored in non-volatile memory.

If a selected local station fades as the vehicle moves out of its service area a special version of the tuning window appears as shown in Figure 5. This gives the listener the option of holding the selected station (50), or moving to other local stations (52,54) available in the area to which the vehicle has moved.

Thus it will be seen that the receiver provides a means for menu-driven selection of stations. This is achieved by the use of "soft keys" on a touch-sensitive display. The information displayed and hence the format of the "soft keys" is configured in response to the RDS information currently available to the receiver off air. The display and soft keys can be arranged by the user as he wishes to simplify selection of frequently selected frequencies.

Conventional volume, tone, and tape or compact disc controls will normally be provided separate from the display. However they could alternatively also be operated via the touch-sensitive display.

Preferably the receiver includes a voice synthesiser 28 coupled between the control microprocessor 24 and the audio amplification circuits 16, as shown in dashed lines in Figure 1. When this is included the synthesiser reads out the function selected on the touch sensitive display prior to execution of the function.

Thus to select a station, or perform any other operation, the listener touches the display as shown in Figure 2, to change it to the manu page of Figure 3. When an area of the display is now touched the speech synthesiser 28 reads out the label displayed in that area. If more than one area is activated, the receiver reads out the area activated first, or else the area on which the centre of the finger is located.

If the enter bar is pressed in the normal display mode of Figure 2, without the display being touched, the voice synthesiser reads out the displayed information 30 to 38 of Figure 3.

While the example illustrated has been given in terms of a car radio, the invention may be embodied in other types of fixed or portable radio receiver.

**Claims**

1. A radio receiver comprising a broadcast signal tuning section (14) for receiving radio signals, sound signal amplifier means (16) coupled to the broadcast signal tuning section to apply an audio signal to an output, control and storage means (24) having an output connected to control the signal tuning section, characterised by data decoding means (22) coupled to the signal tuning section to decode received data signals associated with the receiver radio signal and having an output connected to the control and storage means, and a touch-sensitive display (26) connected to the control and storage means to display received data and to control the radio tuning in response to touching of the display.

2. A radio receiver according to claim 1, characterised by a speech synthesiser (28) coupled between the control and storage means and the sound signal amplifier means.

3. A radio receiver according to claim 1 or 2, characterised in that the display content is adaptively dependent upon the data decoded by the data decoding means.

4. A radio receiver according to claim 3, characterised in that in one mode of operation the display is formatted as a plurality of selectively-touchable areas to select different stations and/or receiver functions.

5. A radio receiver according to claim 3 or 4, characterised in that in at least one mode of operation the display is stored in predetermined format, and in which that format can be changed by selective touching of the display.

**FIG.1**

Diagram labels: 12 (antenna) → R.F. TUNING (14) → AUDIO AMPLIFICATION (16) → 18 (speaker); DATA DECODER (22); VOICE SYNTHESISER (28); CONTROL & STORAGE MICROPROCESSOR (24); TOUCH-SENSITIVE DISPLAY (26); 20; 10.

FIG.2

| | |
|---|---|
| 13-00 | Thu 10 |

BBC R4

stereo

93.5 MHz

30, 32, 34, 36, 38

FIG.3

| BBC R1 | BBC R2 | | mode | scroll ↕ | TA |
|---|---|---|---|---|---|
| | | TP | | | printer |
| BBC R3 | BBC R4 | | PS/ PTY | | TP seek |
| LONDON | LBC | | M | Clear | Traffic News |

tuning window 40 · screen mode window 42 · aux. function window 44

FIG.4

| Pop music | Light music |
|---|---|
| Classical music | Speech |
| Current affairs | News |

FIG.5

| Hold | |
|---|---|
| Oxford | Northampton |

50, 52, 54